# EUROPEAN PATENT APPLICATION

(11) **EP 3 089 233 A1**
(43) Date of publication of application: **02.11.2016**
(21) Application number: 16167138.3
(22) Date of filing: 26.04.2016
(51) Int. Cl.: H01L 51/52, H01L 27/32

(54) **DISPLAY DEVICE AND MANUFACTURING METHOD THEREOF**

(30) Priority: 30.04.2015 US 201562154866 P
(71) Applicant: EverDisplay Optronics (Shanghai) Limited, Shanghai 201500 (CN)
(72) Inventor: WU, Chienlin, Shanghai, P.R. (CN); CHEN, Yiming, Shanghai, P.R. (CN); CHEN, Pinghung, Shanghai, P.R. (CN)
(74) Representative: Loyer & Abello

(57) **Abstract**

The invention provides a display structure and manufacturing method of a display device, and relates to the field of display device technology. By forming a complex encapsulation film with the function of buffering and water-and-oxygen barrier on a display module directly, and attaching the cover on the complex encapsulation film, so as to ensure the sealing effect of the display module, and to efficiently prevent the display screen from breaking caused by the stress concentration generated by impact of external forces, thus the probability of breaking of display screen can be reduced effectively, and the structural strength of the display device as a whole is greatly improved.

## Description

### TECHNICAL FIELD

The invention relates to the field of display device technology, more particularly, to a display structure and manufacturing method of a display device.

### BACKGROUND OF THE INVENTION

The display screen is an important element of the display device, the structural strength thereof may directly effect how the entire display device is affected by the external force. Especially, with respect to the current mobile devices (such as smart phone, tablet etc.), the display screen thereof functions as the main interface of users operation, and would directly determine whether the entire device is able to be operated.

In the conventional methods of manufacturing display screens, two glass substrates are configured to fix and encapsulate display components; since the relative motion of the two glass substrate is limited when the display screen is suffered from the external force caused by falling down and so on, while the glass substrate itself is easy to be broken and has a weak capability to resist against the external force, therefore the entire manufactured display screen is easy to be broken due to inner stress and other factors when operating, even the encapsulation failure or glass breaking may happen, thus it greatly reduces the structural strength of the device as a whole.

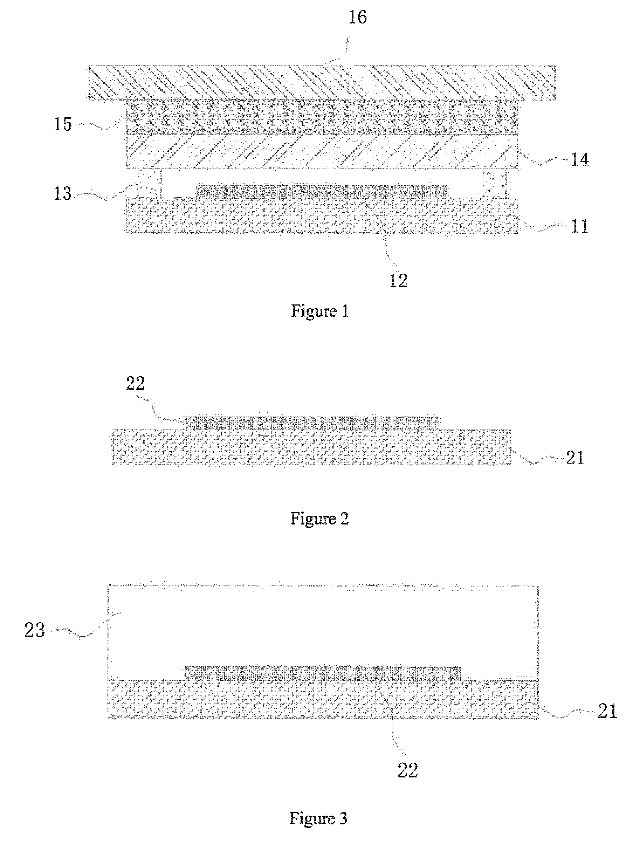

Figure 1 is structure diagram of a conventional display screen. As shown in Figure 1, a light emitting component 12 is configured on a glass substrate 11, and an encapsulation glass 14 is covered on the above-mentioned glass substrate 11 by an encapsulation material 13, so as to encapsulate the above-mentioned light emitting component 12 into a sealed cavity. In addition, an optical film 15, a cover glass 16 and other components are attached on the above-mentioned encapsulation glass 14 successively. Since the above-mentioned glass substrate 11 and the encapsulation glass 14 are fixed and attached through the encapsulation material 13, when the display screen is suffered from the external force caused by falling down and other motion, the display screen is easy to be broken (and even crush) due to the aggregating of inner stress, thus the entire device structure may be damaged.

### SUMMARY OF THE INVENTION

To solve the above-mentioned technical problem, this invention provides a display structure capable of being used in a display device, and the display structure comprising:
a rigid substrate, having a driving circuit therein;
a display module disposed on the surface of the rigid substrate and connected to the driving circuit to be able to be driven by the driving circuit;
a complex encapsulation film fully covering the display module on the rigid substrate to seal the display module, wherein the complex encapsulation film comprises a combination of organic and inorganic layers; and
a cover attached on the complex encapsulation film.

As a preferred embodiment, the display structure further comprises an optical film disposed between the cover and the complex encapsulation film, such that the cover is attached with a portion of top surface of the complex encapsulation film through the optical film, wherein the portion of top surface of the complex encapsulation film is substantially parallel to the cover or the rigid substrate.

As a preferred embodiment, in the above-mentioned display structure:
the cover comprises a touch panel and a cover glass, and the touch panel is stacked with the cover glass, and the optical film is attached on the touch panel.

As a preferred embodiment, in the above-mentioned display structure:
the rigid substrate is a glass based substrate.

As a preferred embodiment, in the above-mentioned display structure:
the display module has a light emitting surface configured to emit light, and a backlight surface opposite to the light emitting surface; and
the backlight surface of the display module is attached on the surface of the rigid substrate, and the complex encapsulation film covers the light emitting surface of the display module.

As a preferred embodiment, the combined organic and inorganic layers of the complex encapsulation film are all made of transparent materiel.

As a preferred embodiment, in the above-mentioned complex encapsulation film comprises a water-and-oxygen barrier layer and a buffering layer, and the water-and-oxygen barrier layer is stacked with the buffering layer.

As a preferred embodiment, in the above-mentioned display structure:
the water-and-oxygen barrier layer and/or the buffering layer are/is composite layer film.

As a preferred embodiment, in the above-mentioned display structure:
the water-and-oxygen barrier layer and/or the buffering layer are/is single layer film.

As a preferred embodiment, in the above-mentioned display structure:

The invention further provides a manufacturing method of a display device, capable of manufacturing a display structure of any of the above-mentioned display structures, which comprising:
providing a rigid substrate with a driving circuit therein;
forming a display module on the rigid substrate, electronically connected to the driving circuit;
forming a complex encapsulation film to fully cover an exposed surface of the display module to seal the display module on the rigid substratee; and
providing a cover on the complex encapsulation film; wherein
the complex encapsulation film comprises at least a water-and-oxygen barrier layer and a buffering layer, and the water-and-oxygen barrier layer is stacked with the buffering layer.

As a preferred embodiment, in the above-mentioned manufacturing method:
the cover comprises a touch panel and a cover glass, and the touch panel is stacked with the cover glass.

As a preferred embodiment, in the above-mentioned manufacturing method:
the display module have a light emitting surface configured to emit light, and a backlight surface opposite to the light emitting surface; and
the backlight surface of the display module is attached on the surface of the rigid substrate, and the complex encapsulation film covers the light emitting surface of the display module.

As a preferred embodiment, in the above-mentioned manufacturing method:
the water-and-oxygen barrier layer and the buffering layer are both made of transparent material.

As a preferred embodiment, in the above-mentioned manufacturing method:
the water-and-oxygen barrier layer and/or the buffering layer are/is composite layer film.

As a preferred embodiment, in the above-mentioned manufacturing method:
the water-and-oxygen barrier layer is an organic layer, an inorganic layer or an organic/inorganic stacking layer.

The above technical solution has the following advantages or beneficial effects:

The technical solution of this invention is to directly form an complex encapsulation film with the function of buffering and water-and-oxygen barrier on a display module; and to attach the cover on the complex encapsulation film, so as to ensure the sealing effect of the display module, and to efficiently prevent the display screen from breaking caused by the stress concentration generated by impact of external forces; therefore, the probability of breaking of the display screen can be reduced effectively, and the structural strength of the display device as a whole is greatly improved.

### BRIEF DESCRIPTIONS OF THE DRAWINGS

The accompanying drawings, together with the specification, illustrate exemplary embodiments of the present disclosure, and, together with the description, serve to explain the principles of the present invention.
Figure 1 is a structural diagram for a general display screen;
Figures 2 to 6 are procedure diagrams of manufacturing a display screen of embodiments of the invention.

### DETAILED DESCRIPTION

The present invention will now be described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" or "has" and/or "having" when used herein, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

As used herein, "around", "about" or "approximately" shall generally mean within 20 percent, preferably within 10 percent, and more preferably within 5 percent of a given value or range. Numerical quantities given herein are approximate, meaning that the term "around", "about" or "approximately" can be inferred if not expressly stated.

As used herein, the term "plurality" means a number greater than one.

Hereinafter, certain exemplary embodiments according to the present disclosure will be described with reference to the accompanying drawings.

This invention provides a display structure and manufacturing method of a display device, and is mainly to encapsulate a display module (such as OLED) disposed on a rigid substrate surface through the technology of Thinning Film Encapsulation, that is to say, to encapsulate the display module by forming a complex encapsulation film capable of buffering and water-and-oxygen barrier, and to form a display structure by attaching the cover on the complex encapsulation film, so as to ensure the sealing effect of the display module, and to efficiently prevent the display screen from breaking, smashing and other defects caused by the stress concentration generated by impact of external forces; therefore, the structural strength of the display device as a whole is greatly improved.

Hereinafter, certain exemplary embodiments according to the present disclosure will be described with reference to the accompanying drawings.

### Embodiment 1

Figures 2 to 6 are procedure diagrams of manufacturing a display screen of embodiments of the invention. As shown in Figures 2 to 6, the invention provides a method of manufacturing a display device, which comprising:
first, providing a rigid substrate 21, which comprises a front surface configured to form a display device (the upper surface shown in Figure 2) and a back surface (the lower surface shown in Figure 2) opposite to the front surface; preferably, a glass substrate may be selected as the rigid substrate 21; and a driving circuit used to drive the subsequently formed display module to emit light, such as circuit components and the relevant structure etc., is configured on/inside the rigid substrate 21.

Second, forming a display module 22 on the above-mentioned front surface of the rigid substrate 21 shown in Figure 2, and connecting the display module 22 with the above-mentioned driving circuit (not shown), so as to use the driving circuit to drive the display module 22 to work; and the display module 22 has a light emitting surface configured to emit light, and a backlight surface opposite to the light emitting surface; in addition, the display module 22 may be an OLED module or other types of light-emitting module.

Third, forming a complex encapsulation film 23 capable of buffering and water-and-oxygen barrier by thin-film encapsulation process; namely, the complex encapsulation film 23 is transparent and fully covers the above-mentioned display module 22 (i.e. the upper surface and the side wall shown in Figure 3) to seal the display module on the rigid substrate, so as to enable the light emitted from the display module 22 to pass through the complex encapsulation film 23 and display image; meanwhile, the complex encapsulation film 23 also covers the exposed front surface of the rigid substrate 21 adjacent to the display module 22, the complex encapsulation film 23 fully covers the display module 22 on the front surface of the rigid substrate 21, so as to seal and encapsulate the display module 22 together with the above-mentioned rigid substrate 21, so that the corrosion of the display module 22 caused by external water and oxygen can be prevented efficiently, and the damage to the display module 22 from the external impact force can be buffered; forming an optical film 24 on a portion of surface of the complex encapsulation film 23, wherein the portion of surface of the complex encapsulation film 23 is substantially parallel to the rigid substrate 21.

Preferably, the thickness of the above-mentioned complex encapsulation film 23 is larger than the thickness of the display module 22, and the top of the complex encapsulation film 23 is shown as a horizontal plane by planarization process, so as to attach the sequent optical film with the cover and other components.

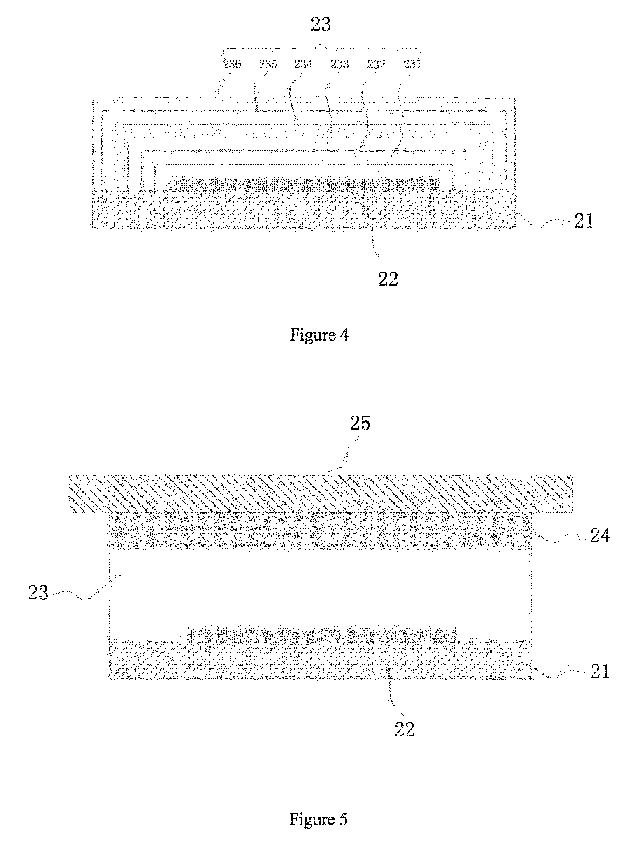

Preferably, as shown in Figure 4, the above-mentioned complex encapsulation film 23 may comprises a combination of organic and inorganic layers, and at least includes a water-and-oxygen barrier layer and a buffering layer, and the water-and-oxygen barrier layer is stacked with the buffering layer, and each thin film layer can seal the display module 22 on the front surface of the rigid substrate 21 separately; it is sure that the complex encapsulation film 23 may be a single layer structure capable of buffering and water-and-oxygen barrier, and the specific configuration depends on the requirements of the practical process.

As shown in Figure 4, in the specific manufacturing process, the procedure of manufacturing a complex encapsulation film 23 with a combination of organic and inorganic layers, is to form a first film layer 231 to cover the above-mentioned display module 22 and the rigid substrate 21, remove the redundant film layer structure, and then form a second film layer 232 to cover the above-mentioned first film layer 231 and the exposed surface of rigid substrate 21, repeat the above-mentioned manufacturing process of film layer multiple times, so as to form an complex encapsulation film 23 with a combination of organic and inorganic layers finally (i.e. as shown in Figure 4, the display module 23 may comprises a first film layer 231, a second film layer 232, a third film layer 233, a forth film layer 234, a fifth film layer 235 and a sixth film layer 236; it is sure that the skilled person in the art can add a new film layer structure or reduce a part of the film layer structure in accordance with the requirements of process, so as to make the formed complex encapsulation film 23 capable of buffering and water-and-oxygen barrier).

Preferably, the buffering layer and water-and-oxygen barrier layer of the above-mentioned complex encapsulation film 23 can be configured as composite film layer; a thin film layer of a single film layer can also be used; the buffering layer covers the water-and-oxygen layer and the display module 23, and the buffering layer and the water-and-oxygen barrier layer may be configured alternatively, such as the first film layer 231, the third film layer 233 and the fifth film layer 235 may be buffering layer, and the second film layer 232, the fourth film layer 234 and the sixth film layer 236 can be water-and-oxygen barrier layer; to achieve the best capability of buffering and water-and-oxygen barrier, the outermost layer (such as the sixth film layer 236) and the innermost layer (such as the first film layer 231) of the complex encapsulation film 23 are all configured as buffering layers, so as to efficiently protect the display module 22 and buffer the maximum external impact force; meanwhile, the middle film layer(s) (such as the second layer 232 to the fifth layer 235) is configured to be water-and-oxygen barrier layer, so as to ensure the sealing property of the display module 22.

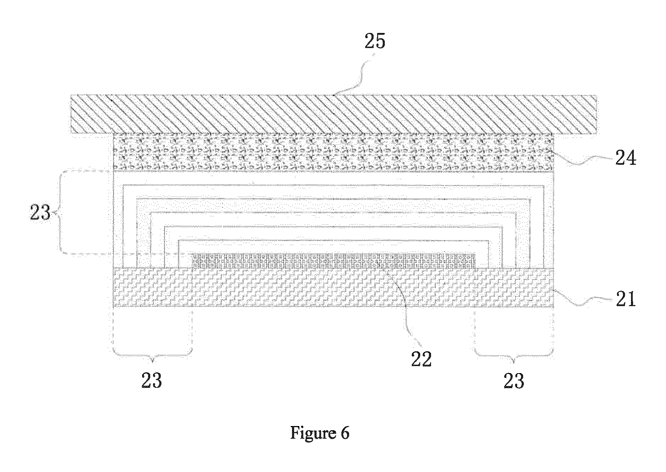

In the end, continuing the encapsulation process, attaching the optical film 24 and cover 25 to the top surface of the complex encapsulation film 23 successively (i.e. the upper surface shown in Figures), forming the display device structure (shown in Figure 5) on the basis of the complex encapsulation film 23 with the single layer structure (shown in Figure 3), or forming the display device structure (shown in Figure 6) on the basis of the complex encapsulation film 23 with the combination of organic and inorganic layers (shown in Figure 4); the above-mentioned cover 25 may comprises a touch panel and a cover glass, and the touch panel is stacked with the cover glass; as the display module 22 may be fully covered by the complex encapsulation film 23 capable of buffering and water-and-oxygen barrier, the damage of the external impact force generated by the encapsulation process to the display module 22 can be efficiently avoided, meanwhile the structural strength of the encapsulated and manufactured display device as a whole is improved efficiently.

### Embodiment 2

On the basis of the above-mentioned embodiment 1, as shown in Figures 5 to 6, the invention further provides a display structure which can be used to form various kinds of display devices, and the above-mentioned display structure comprising:
a rigid substrate 21, having a front surface (i.e. the upper surface shown in Figures 5 and 6) for configuring a device and a lower surface (i.e. the lower surface shown in Figures 5 and 6) opposite to the upper surface; the rigid substrate 21 may be made of a glass based substrate, and a driving circuit, which is configured to drive the display module to emit light, may be configured on/inside the substrate 21.

A display module 22, disposed on the front surface of the above-mentioned rigid substrate 21 and partially covering a part of the front surface of the rigid substrate 21, and connected with the above-mentioned driving circuit so as to use the driving circuit to drive the display module 22 to work; the display module 22 has a light-emitting surface for emitting light (i.e. the upper surface shown in Figures 5 and 6) and a backlight surface (i.e. the lower surface shown in Figures 5 and 6) opposite to the light-emitting surface; in other word, the above-mentioned backlight surface of the display module 22 is attached to the front surface of the rigid substrate 21.

Preferably, the above-mentioned display module 22 may be an OLED module, or may be other types of light-emitting module.

A complex encapsulation film 23, fully covering the above-mentioned light-emitting surface of the display module 22, the side wall of the display module 22, and the exposed front surface of the surface 21 adjacent to the display module 22, so as to seal the display module 22 on the front surface of the rigid substrate 21; the complex encapsulation film 23 may have the barrier properties of water and oxygen and the buffering property, so as to seal the display module 22 and be able to efficiently buffer the damage from external impact force to the display module 22; the complex encapsulation film comprises a combination of organic and inorganic layers.

Preferably, the complex encapsulation film 23 may be made from transparent material, so that the light emitted from the display module 22 can be emitted there-through; meanwhile, the complex encapsulation film 23 may be a single layer film structure or a combination of organic and inorganic layers.

Preferably, if the complex encapsulation film 23 is a combination of organic and inorganic layers, the complex encapsulation film 23 may comprises a water-and-oxygen barrier layer and a buffering layer, and the water-and-oxygen barrier layer is stacked with the buffering layer, and the water-and-oxygen barrier layer and/or the buffering layer may be a single layer film and/or a composite layer film.

Preferably, each water-and-oxygen barrier layer can seal the display module 22 individually, meanwhile each buffering layer can cover the display module 22 on the front surface of the rigid substrate 21, so as to effectively prevent the display module 22 from the damage caused by external impact force.

Preferably, the water-and-oxygen barrier layer may be an organic layer, an inorganic layer or an organic/inorganic stacking layer.

A cover 25 is attached on the above-mentioned complex encapsulation film 23 through the optical film 24; and the cover 25 further comprises a touch panel, a cover glass and so on, and the touch panel is stacked with the cover glass.

Preferably, the above-mentioned optical film 24 is attached on the touch panel and the cover glass successively, so as to attach the above-mentioned cover 25 onto the complex encapsulation film 23.

It is noted that the structure provided by the embodiment can be manufactured via the method disclosed in embodiment 1, therefore the manufacturing process, the film layer material, the relationship between the film layers, and the other technical features discloses in embodiment 1 can all be applied to the structure of this embodiment, and is not to be repeated herein.

In summery, the display structure and manufacturing method of the display device of the embodiments of the invention is to utilize the complex encapsulation film formed by thin-film encapsulation process to encapsulate the display module on the rigid substrate directly, and the complex encapsulation film is capable of buffering and water-and-oxygen barrier, so as to ensure the sealing effect of the display module, and efficiently buffer the outer impact force in the subsequently encapsulation process, meanwhile the formed display device structure is able to efficiently buffer the outer impact force caused by falling, bumping and so on, so as to greatly reduce the possibility of screen breaking, screen crashing and other defects caused by stress concentration generated by impact of external forces, and improves the structural strength of the display device as a whole to efficiently improve the performance and yield of manufacturing the display device.

The foregoing is only the preferred embodiments of the invention, not thus limiting embodiments and scope of the invention, those skilled in the art should be able to realize that the schemes obtained from the content of specification and figures of the invention are within the scope of the invention.

## Claims

1. A display structure, **characterized in that**:
a rigid substrate (21), having a driving circuit therein;
a display module (22) disposed on the rigid substrate (21) and connected to the driving circuit to be able to be driven by the driving circuit;
a complex encapsulation film (23), fully covering the display module (22) on the rigid substrate (21) to seal the display module (22), wherein the complex encapsulation film (23) comprises a combination of organic and inorganic layers; and
a cover (25), attached on the complex encapsulation film (23).

2. The display structure of claim 1, **characterized in that** the display structure further comprises an optical film (24) disposed between the cover (25) and the complex encapsulation film (23), such that the cover (25) is attached with a portion of top surface of the complex encapsulation film (23) through the optical film (24), wherein the portion of top surface of the complex encapsulation film (23) is substantially parallel to the cover (25) or the rigid substrate (21).

3. The display structure of claim 2, **characterized in that** the cover (25) comprises a touch panel and a cover glass, and the touch panel is stacked with the cover glass, and the optical film (24) is attached on the touch panel.

4. The display structure of claim 1, **characterized in that** the rigid substrate (21) is a glass based substrate.

5. The display structure of claim 1, **characterized in that**
the display module (22) has a light emitting surface configured to emit light, and a backlight surface opposite to the light emitting surface; and
the backlight surface of the display module (22) is attached on surface of the rigid substrate (21), and the complex encapsulation film (23) covers the light emitting surface of the display module (22).

6. The display structure of claim 1, **characterized in that** the combined organic and inorganic layers of the complex encapsulation film (23) are all made of transparent materiel.

7. The display structure of claim 6, **characterized in that** in the complex encapsulation film (23) comprises a water-and-oxygen barrier layer and a buffering layer, and the water-and-oxygen barrier layer is stacked with the buffering layer.

8. The display structure of claim 7, **characterized in that** the water-and-oxygen barrier layer and/or the buffering layer are/is composite layer film.

9. The display structure of claim 7, **characterized in that** the water-and-oxygen barrier layer and/or the buffering layer are/is a single layer film.

10. A method of manufacturing a display device, **characterized in that** the method comprises:
providing a rigid substrate (21) with a driving circuit formed therein;
forming a display module (22) on the rigid substrate (21) to electronically connected to the driving circuit;
forming a complex encapsulation film (23) to fully cover the display module (22) to seal the display module (22) on the rigid substrate (21); and
providing a cover (25) on the complex encapsulation film (23); wherein
the complex encapsulation film (23) comprises at least a water-and-oxygen barrier layer and a buffering layer, and the water-and-oxygen barrier layer is stacked with the buffering layer.

11. The method of claim 10, **characterized in that** after the complex encapsulation film (23) forming step, it further comprises: forming an optical film (24) on a portion of surface of the complex encapsulation film (23), wherein the portion of surface of the complex encapsulation film (23) is substantially parallel to the rigid substrate (21).

12. The method of claim 11, **characterized in that** the step of providing the cover (25) on the complex encapsulation film (23) comprises: providing the cover (25) to be attached to the optical film (24), such that the cover (25) is connected to the complex encapsulation film (23) through the optical film (24).

13. The method of claim 10, **characterized in that** the cover (25) comprises a touch panel and a cover glass, and the touch panel is stacked with the cover glass.

14. The method of claim 10, **characterized in that**
the display module (22) has a light emitting surface configured to emit light, and a backlight surface opposite to the light emitting surface; and
the backlight surface of the display module (22) is attached on the surface of the rigid substrate (21), and the complex encapsulation film (23) covers the light emitting surface of the display module (22).

15. The method of claim 10, **characterized in that** the water-and-oxygen barrier layer and the buffering layer are made of transparent material.

16. The method of claim 15, **characterized in that** the water-and-oxygen barrier layer and/or the buffering layer are/is composite layer film.

17. The method of claim 10, **characterized in that** the water-and-oxygen barrier layer is an organic layer, an inorganic layer or an organic/inorganic stacking layer.
